# EUROPÄISCHE PATENTSCHRIFT

(11) **EP 3 167 095 B1**
(45) Veröffentlichungstag und Bekanntmachung des Hinweises auf die Patenterteilung: **26.02.2020**
(21) Anmeldenummer: 15745358.0
(22) Anmeldetag: 30.06.2015
(51) Int. Cl.: C23C 14/34, H01J 37/34, C23C 24/04

(54) **TARGET UND VERFAHREN ZUR HERSTELLUNG EINES TARGETS**
TARGET AND METHOD FOR PRODUCING A TARGET
CIBLE ET PROCÉDÉ POUR LA FABRICATION D'UNE CIBLE

(30) Priorität: 08.07.2014 AT 2762014 U
(43) Veröffentlichungstag der Anmeldung: 17.05.2017
(73) Patentinhaber: Plansee SE, 6600 Reutte (AT); PLANSEE COMPOSITE MATERIALS GMBH, DE-86983 Lechbruck am See (DE)
(72) Erfinder: GRADINGER, Rudolf, 2320 Schwechat (AT); KATHREIN, Martin, Tehuacan, PUEBLA CP 75760 (MX); KOLOZSVARI, Szilard, 86899 Landsberg am Lech (DE); POLCIK, Peter, 6600 Reutte (AT)
(74) Vertreter: Ciesla, Bettina
(86) Internationale Anmeldenummer: PCT/AT2015/000091
(87) Internationale Veröffentlichungsnummer: WO 2016/004447

(56) Entgegenhaltungen:
- JP-A- 2001 295 040
- KR-A- 20130 132 325
- US-A1- 2011 303 535
- US-A1- 2013 220 805
- US-A1- 2013 299 347
- US-B1- 8 709 335

## Beschreibung

Die Erfindung betrifft ein Target und ein Verfahren zu dessen Herstellung. Ein erfindungsgemäßes Target ist für die Verwendung in einem PVD (physical vapor deposition, physikalische Dampfabscheidung) Prozess zur Abscheidung von Schichten auf ein dafür vorgesehenes Substratmaterial geeignet. Im Sinne der Erfindung sind unter dem Begriff Target Sputtertargets beziehungsweise Arc Kathoden zu verstehen.

Eine Komponente eines Target ist das Targetmaterial, das im Zuge des PVD Prozesses abgetragen und auf das zu beschichtende Substrat abgeschieden wird. In den meisten Fällen ist dieses Targetmaterial auf einer oder mehreren Stützplatten angebracht beziehungsweise mit diesen verbunden.

Zum Beispiel offenbart WO 2011/092027 A1 ein Sputtertarget für eine Magnetronsputteranlage, wobei das Target mindestens drei Targetplatten aufweist, die mit einer Stützplatte verbunden sind. Beispielsweise mittels Schweißen, Löten oder Angießen kann die Stützplatte an den Targetplatten befestigt werden.

Es ist auch bekannt, Targetmaterial anstelle herkömmlicher Verfahren wie zum Beispiel Löten, über Spritzverfahren auf entsprechende Stützplatten aufzubringen. So offenbart US 2008/0271779 A1, dass ein pulverförmiges Targetmaterial direkt auf eine Stützplatte oder ein Stützrohr aufgebracht wird, um so ein Target mit einer gleichmäßigen Korngröße von unter 44 µm in einem Schritt zu fertigen.

Ein ähnliches Verfahren für das Spritzen von Targetmaterial offenbart WO 2008/81585 A1, in der beispielsweise pulverförmiges Targetmaterial aus Aluminium oder Kupfer auf Stützplatten aus Kupfer oder Silizium gespritzt wird.

WO 2006/117145 wiederum offenbart eine Methode für die Wiederaufbereitung oder Produktion von Sputtertargets oder Röntgenanoden mittels eines solchen Spritzverfahrens im Speziellen für Refraktärmetalle. Dabei werden Pulver aus Niob, Tantal, Wolfram, Molybdän, Titan, Zirkon oder auch Mischungen oder Legierungen daraus verwendet.

Derartige Spritzverfahren bei denen ein pulverförmiges metallisches Material auf ein Substrat abgeschieden wird, ohne dabei das pulverförmige metallische Material aufzuschmelzen, sind beispielsweise auch in EP 1 666 636 A1 beschrieben. Solche Verfahren werden in weit größerem Umfang auch für diverse in anderen Bereichen der Technik eingesetzten Bauteilen verwendet, beispielsweise für über Kaltgasspritzen aufgebrachte Korrosionsschutzschichten stark korrosiv beanspruchter Komponenten. Dies ist beispielsweise durch WO 2008/57710 A2 offenbart. Die beschriebenen Schutzschichten haben eine bevorzugte Dicke von 0,05 bis 10 mm. Dabei ist es besonders wichtig, dass die abgeschiedenen Schichten hohe Reinheit und einen niedrigen Sauerstoff sowie Wasserstoffgehalt aufweisen.

In der KR 2013 0132325A wird eine Targetplatte beschrieben, auf welcher durch Kaltgasspritzen eine Stützplatte aufgebracht wird. Die US 2013/220805A1 offenbart zwischen der Targetplatte und der Stützplatte eine Zwischenschicht. Diese Zwischenschicht soll auftretende Spannungen ausgleichen. Die JP 2001295040Azeigt eine Targetplatte und eine aus mehreren Schichten bestehende Stützplatte, welche durch Diffusion oder Schweißen miteinander verbunden sind.

Für spröde Targetmaterialien sind solche Spritzverfahren jedoch wenig geeignet, Targetplatten aus solchem Material werden üblicherweise über andere Verfahren wie beispielsweise über Pressen von Pulvern und Sintern oder auch schmelzmetallurgisch hergestellt. Gerade für spröde Targetmaterialien ist es oft schwierig, geeignete Materialien für Stützplatten und auch Methoden um Targetplatten mit Stützplatten zu verbinden, zu finden. Somit ist die Herstellung von stabilen Targets erschwert und sehr oft aufwendig und kostenintensiv.

Auch für herkömmliche Targetmaterialien, die in weit größerer Menge ebenfalls üblicherweise über andere Verfahren wie beispielsweise über Pressen von Pulvern und Sintern oder auch schmelzmetallurgisch hergestellt werden, bereitet das Bereitstellen von geeigneten Stützplatten und deren Verbindung mit den Targetplatten oftmals Schwierigkeiten. So ist beispielsweise eine Lötverbindung nur bis zu Einsatztemperaturen unterhalb der Schmelztemperatur des Lotmaterials stabil, was im schlimmsten Fall zu einem Abfallen der Targetplatte während des PVD Prozesses führen kann. Auch ein Unterschied der Wärmeausdehnungskoeffizienten von Targetplatten und Stützplatten kann zu beträchtlichen Problemen, beispielsweise über die Entstehung von Spannungen führen.

Da die Verbindung von Targetplatten mit Stützplatten meist auch mehrere Schritte beinhaltet ist die Herstellung stabiler Targets auch aus produktionstechnischer Sicht aufwendig und kostenintensiv.

Es ist also Aufgabe der Erfindung, ein einfach herstellbares und stabiles Target und ein Verfahren für eine einfache Herstellung eines stabilen Targets bereitzustellen.

Diese Aufgabe wird mit den Merkmalen des Anspruchs 1 bzw. 6 gelöst.

Vorteilhafte Ausgestaltungen sind Gegenstand der Unteransprüche.

Gemäß Anspruch 1 wird ein Target bereitgestellt, das eine Targetplatte aus Targetmaterial und eine Stabilisierungsschicht aufweist, wobei die Stabilisierungsschicht mit der Rückseite der Targetplatte verbunden ist. D.h. die Targetplatte und die Stabilisierungsschicht bilden eine Einheit bzw. bilden das Target. Das Target bzw. die Targetplatte kann je nach Bedarf bzw. Anlage eine beliebige (planare) Form aufweisen, beispielsweise rund oder eckig ausgebildet sein. Die Vorderseite der Targetplatte bzw. des Targets ist die Seite von der bei der Verwendung bei einem PVD Prozess Targetmaterial abgetragen wird bzw. die Seite, die bei der Verwendung in einer Anlage einem zu beschichtenden Substrat zugewandt ist. Die Rückseite der Targetplatte ist die Seite, die bei der Verwendung des Targets von einem zu beschichtenden Substrat abgewandt ist. Die Stabilisierungsschicht ist mittels eines hochkinetischen Spritzverfahrens von Stabilisierungsmaterial auf die Targetplatte aufgebracht bzw. auf dieser erzeugt und die Zusammensetzung der Stabilisierungsschicht weist einen Gradientenverlauf auf. D.h. durch einen derartigen Spritzvorgang wird auf der Targetplatte nach und nach eine Stabilisierungsschicht aufgebaut, so dass die gesamte/vollständige Stabilisierungsschicht mittels dieses Spritzvorganges hergestellt ist. Eine solche Stabilisierungschicht kann sowohl nur auf der Rückseite der Targetplatte, als auch zumindest teilweise auf den Seiten- oder Umfangflächen aufgebracht werden.

Hochkinetische Spritzverfahren sind Verfahren, bei denen ein Beschichtungswerkstoff in Pulverform mit sehr hoher Geschwindigkeit auf ein Substrat aufgebracht wird. Dazu wird ein Prozessgas (beispielsweise Stickstoff, Luft, Edelgase, Wasserdampf) durch Expansion in einer Düse (meist in einer Konvergent-/Divergentdüse wie beispielsweise einer Lavaldüse) auf sehr hohe Geschwindigkeit beschleunigt und anschließend werden die Pulverpartikel in den Gasstrahl injiziert. Alternativ werden die Pulverpartikel gemeinsam mit dem Prozessgas beschleunigt. Die Partikel werden dabei auf eine so hohe Geschwindigkeit beschleunigt, dass sie beim Aufprall auf das Substrat eine dichte und fest haftende Schicht bilden. Für die vorliegende Erfindung geeignete hochkinetische Spritzverfahren sind zum Beispiel das Kaltgasspritzen oder Wasserdampfauftragsverfahren.

Eine durch ein hochkinetisches Spritzverfahren aufgebrachte Stabilisierungsschicht weist eine Mikrostruktur auf, die direkt aus dem verwendeten Verfahren resultiert. So werden die Pulverpartikel beim Aufprall auf das Substrat kaltverformt, die entstehende dichte und festhaftende Schicht zeigt also eine verformte Mikrostruktur mit länglicher Ausprägung der vormaligen Pulverpartikel. Durch hochkinetische Spritzverfahren aufgebrachte Stabilisierungsschichten weisen typischerweise ein mittleres Aspektverhältnis von größer 2 und meist zwischen 2 und 10 auf. Sowohl die Partikelgröße in der Stabilisierungsschicht (vormalige Pulverpartikel) als auch das Aspektverhältnis kann einfach über ein Linienschnittverfahren an einem metallographischen Querschliff bestimmt werden. Dabei ist die für die Bestimmung des Aspektverhältnis herangezogene längere Achse parallel zur Oberfläche der gespritzten Schicht, die kürzere Achse normal dazu.

Entsprechend der Dauer des Spritzvorgangs kann eine stabile Schicht mit einer Dicke von bis zu mehreren Millimetern oder Zentimetern auf der Targetplatte aufgebaut werden. Insbesondere findet der Spritzvorgang bei niedrigen Temperaturen statt, die unterhalb des Schmelzpunkts des Targetmaterials bzw. Stabilisierungsmaterials liegen. D.h. die Targetplatte verformt sich während des Aufspritzens der Stabilisierungsschicht nicht oder nicht wesentlich. Durch das Aufspritzen können jedoch Spannungen in die Targetplatte eingebracht werden bzw. auch nach dem Spritzvorgang in der Stabilisierungsschicht verbleiben.

Die Stabilisierungsschicht wirkt als funktionelle Rückplatte bzw. Versteifungselement und dient der Erhöhung der Steifigkeit (E-Modul) bzw. Verstärkung der Targetplatte. D.h. die Festigkeit und Steifigkeit der Targetplatte bzw. des Targets werden durch das Aufbringen der Stabilisierungsschicht gesteigert, sodass sich das Target bei der Verwendung in einer PVD-Anlage nicht bzw. nicht wesentlich verformt. Üblicherweise werden in solchen PVD-Anlagen die verwendeten Targets über flexible (verformbare) Kühlplatten gekühlt die auf der Rückseite der Targets angeordnet sind. Durch diese Kühlplatten wird ein Druck auf die Targets ausgeübt, was wiederum zu einer Verformung der Targets, oder bei zu geringer Festigkeit derselben zum Bruch führen kann. Dieser Effekt wird zusätzlich dadurch verstärkt, dass sich die Stärke des Targets während des Beschichtungsprozesses durch den Abtrag verringert. Dies hat zur Folge, dass es noch wahrscheinlicher zu Verformung und oder Bruch des Targets kommen kann. Durch das Aufbringen einer Stabilisierungsschicht mit erhöhter Festigkeit bzw. Steifigkeit werden solche Versagensfälle weitgehend vermieden.

Bei der Verwendung solcher Targets in einer PVD-Anlage treten häufig hohe Temperaturen und oder große Temperaturgradienten auf, die durch die Einbringung hoher Leistungsdichten von > 10W/cm² verursacht werden. Solcherart erzeugte Temperaturen bzw. Temperaturgradienten müssen über das Target (bzw. die Targets) zur Kühlplatte abgeführt werden und üben eine hohe Thermowechselbeanspruchung auf dieses aus. In Ausführungsformen der Erfindung wirkt die Stabilisierungsschicht als Wärmesenke, d.h. durch das Aufspritzen von Stabilisierungsmaterial mit einer im Vergleich zur Targetplatte erhöhten Wärmeleitfähigkeit kann die im PVD Prozess auf der dem Substrat zugewandten Targetseite (Vorderseite) entstehende Wärme besser über das Target abgeführt werden.

Eine über ein hochkinetisches Spritzverfahren aufgebrachte Stabilisierungsschicht wirkt sich also über zumindest einen der folgenden Effekte positiv auf die Lebensdauer und die Funktionsweise eines erfindungsgemäßen Targets aus:
- Erhöhung der Festigkeit
- Erhöhung der Steifigkeit
- Erhöhung der Wärmeleitfähigkeit.

Weiters kann durch die Aufbringung einer Stabilisierungsschicht die mechanische Bearbeitung der Targetrückseite, entsprechend der Vorgaben zur Befestigung des Targets in der Beschichtungsanlage, bei schwer zerspanbarem Targetmaterial erleichtert werden.

Durch den Spritzvorgang wird zum einen eine äußerst stabile Verbindung zwischen Targetplatte und Stabilisierungsschicht hergestellt, und zum anderen kann eine äußerst dichte Stabilisierungsschicht erzeugt werden. Über ein erfindungsgemäßes Verfahren können Stabilisierungsschichten mit relativen Dichten von > 98% hergestellt werden. Die relative Dichte der aufgebrachten Stabilisierungsschicht kann einfach über die Durchführung einer Dichtemessung im Auftriebsverfahren festgestellt werden.

Durch den Spritzvorgang wird der Gehalt an den Elementen H, N, O in der Stabilisierungsschicht (im Vergleich zu den Gehalten der Ausgangspulver) nicht oder im Wesentlichen nicht erhöht oder verändert. Der Gehalt dieser Elemente kann über eine chemische Analyse festgestellt werden.

Ein erfindungsgemäßes Verfahren ist besonders vorteilhaft, wenn sich die verwendete Targetplatte aufgrund des technologisch bedingten Herstellungsweges bzw. der technologischen Rahmenbedingungen nur schlecht mit dem für die Stabilisierungsschicht verwendeten Werkstoff verbinden lässt. Dies gilt insbesondere bei großen Unterschieden zwischen den Schmelzpunkten oder der Umformbarkeit der Werkstoffe aus denen zum einen die Targetplatte und zum anderen die Stabilisierungsschicht bestehen.

Besonders geeignet ist ein erfindungsgemäßes Verfahren für Targetplatten aus Aluminium-Basis Werkstoffen, Chrom-Basis Werkstoffen, Titan-Basis Werkstoffen oder Keramiken.

Als Aluminium-Basis Werkstoffe sind hier sowohl Aluminiumlegierungen als auch Aluminium-Verbundwerkstoffe zu verstehen, die mindestens 50 at% Aluminium enthalten, beispielsweise in den Zusammensetzungen (in at%) AlTi 75/25, AlTi 67/33, AlTi 50/50 oder AlCr 70/30.

Als Chrom-Basis Werkstoffe sind hier reines Chrom, Chromlegierungen als auch Chrom-Verbundwerkstoffe zu verstehen, die mindestens 50 at% Chrom enthalten, beispielweise in den Zusammensetzungen (in at%) CrB 90/10, CrSi 90/10, CrV 80/20, CrTi 80/20 oder CrW 95/5.

Als Titan-Basis Werkstoffe sind hier reines Titan, Titanlegierungen als auch Titan-Verbundwerkstoffe zu verstehen, die mindestens 50 at% Titan enthalten, beispielweise in den Zusammensetzungen (in at%) TiB 90/10, TiSi 80/20, TiNb 70/30, TiMo 50/50 oder TiW 50/50.

Als Verbundwerkstoffe werden hier Materialien bezeichnet, die aus mehreren Komponenten oder Elementen aufgebaut sind, die jedoch nicht oder nur teilweise ineinander gelöst sind. So wird zum Beispiel eine verdichtete Mischung aus Aluminium-Partikeln mit eingebetteten Chrom-Partikeln als Aluminium-Chrom-Verbundwerkstoff bezeichnet.

Als für Targetplatten in erfindungsgemäßen Targets zu verwendende Keramiken sind hier Boride, Carbide, Nitride, Silizide und Oxide zu verstehen, beispielsweise TiB2, WC, SiC, TiN, CrSi2, MoO3.

Geeignete Werkstoffe für die Verwendung als Stabilisierungsschicht in einem erfindungsgemäßen Target sind zum Beispiel Kupfer, Kupferlegierungen, inklusive Messing und Bronzen, Aluminium, Aluminiumlegierungen, Titan, Titanlegierungen und Stahl.

Bevorzugt ist eine Kombination aus einem Aluminium-Verbundwerkstoff als Targetplatte und Kupfer oder eine Kupferlegierung als Stabilisierungsschicht. Zusätzlich zur Stabilisierung (Reduzierung elastischer und oder plastischer Verformung) der Targetplatte weist eine Stabilisierungsschicht aus Kupfer eine hohe Wärmeleitfähigkeit auf, die z.B. ein effektives Kühlen mittels einer Wasserkühlung an der Rückseite des Targets ermöglicht. Die Wärmeleitfähigkeit von gespritzten Kupferschichten ist mit jener von Bulk-Kupfer vergleichbar.

Eine alternative bevorzugte Ausgestaltung weist eine Stabilisierungsschicht aus Stahl auf einer Targetplatte aus einem Chrom-Verbundwerkstoff auf. Neben der höheren Steifigkeit, bedingt durch den höheren Elastizitätsmodul, weist eine Stabilisierungsschicht aus Stahl eine höhere Duktilität auf, die dem Versagen des Targets durch spröden Bruch entgegen wirkt.

Zusätzlich kann in weiteren Ausgestaltungen der Erfindung auf eine oben beschriebene Stabilisierungsschicht eine oder mehrere weitere Schichten aus Werkstoffen mit im Vergleich zur ersten Schicht unterschiedlicher Steifigkeit, Streckgrenze oder Wärmeleitfähigkeit aufgebracht werden. Besonders vorteilhaft ist es, wenn die eine Schicht oder mehrere weitere Schichten ebenfalls mittels eines hochkinetischen Spritzverfahrens aufgebracht werden, d.h. die gesamte, in einer solchen Ausgestaltung mehrschichtige Stabilisierungsschicht mittels eines solchen Verfahrens auf die Targetplatte gespritzt wird.

So kann zum Beispiel in einer Ausgestaltung eine erste Schicht aus Kupfer oder einer Kupferlegierung durch eine weitere Schicht aus Stahl ergänzt werden. Die zwei Materialien (Kupfer und Stahl) haben hierbei zwei unterschiedliche Wirkungsweisen: Kupfer bietet hervorragende Wärmeleiteigenschaften, so dass Wärme schnell abgeleitet wird und somit das Targetmaterial nicht thermisch überlastet wird, Stahl weist eine etwas höhere Streckgrenze als Kupfer auf und sorgt, auch durch den höheren Elastizitätsmodul, dafür, dass das Targetmaterial den anlagenbedingten Drücken standhält und schützt somit das Target zusätzlich vor elastischer als auch plastischer Verformung. Beispielsweise wird in einigen Anlagen das Target durch den Wasserdruck des Kühlwassers geklemmt, dabei wird der Druck des Kühlwassers durch eine biegsame Membrane - die den Wasserkreislauf von der Vakuumkammer trennt - auf die Rückseite des Targets aufgebracht. Somit wird das Material auf einmal geklemmt und auch gekühlt, also mechanisch als auch thermisch beansprucht.

In einer weiteren bevorzugten Ausführungsform ändert sich die Zusammensetzung der Stabilisierungsschicht senkrecht mit dem Abstand zur Targetplatte. In einer weiteren bevorzugten Ausführungsform ändert sich die Zusammensetzung der Stabilisierungsschicht parallel zur Targetplatte, d.h. z.B. bei einem scheibenförmigen Target in radialer Richtung.

Erfingungsgemäß wird die Zusammensetzung des Stabilisierungsmaterials während des Spritzens auf die Targetplatte verändert, so dass ein Gradientenverlauf bezüglich der Zusammensetzung der Stabilisierungsschicht erhalten wird. Dabei kann sowohl ein Wechsel des Stabilisierungsmaterials erfolgen, als auch ein Stabilisierungsmaterial nach und nach z.B. durch Legieren verändert werden. Ein so eingestellter Gradient kann mit einem Gradienten hinsichtlich der Steifigkeit, der Festigkeit bzw. der Wärmeleitfähigkeit einhergehen. Der Gradientenverlauf kann dabei diskontiunierlich/stufenweise oder kontinuierlich verlaufen, es können auch nur Teile der Stabilisierungsschicht bzw. bei mehrschichtigen Stabilisierungsschichten einzelne Teilschichten gradiert sein.

So kann zum Beispiel in einer Ausgestaltung zunächst reines Kupfer als Stabilisierungsmaterial aufgespritzt und diesem nach und nach eine oder mehrere zusätzliche Komponenten zugegeben werden, um die Steifigkeit und Festigkeit der Stabilisierungsschicht zu steigern. Beispiele dafür sind Kupferlegierungen mit Legierungselementen wie Al, Ni, Fe, Mn, Zn, Sn, Cr, Si, Zr, beispielsweise CuAl oder CuCrZr.

In gleicher Weise können natürlich Titan und Titanlegierungen, beispielsweise Titan mit Vanadium für Ausgestaltungen der Erfindung verwendet werden.

In gleicher Weise können natürlich Aluminium und Aluminiumlegierungen, beispielsweise Aluminium mit Silizium für Ausgestaltungen der Erfindung verwendet werden.

In gleicher Weise können natürlich Stähle mit nach und nach veränderter Zusammensetzung für Ausgestaltungen der Erfindung verwendet werden.

Ein erfindungsgemäßes Target kann beispielsweise rund ausgebildet werden und beispielsweise einen Durchmesser zwischen 50 mm bis 400 mm und eine Stärke oder Dicke zwischen 5 mm und 40 mm aufweisen. Alternativ kann ein erfindungsgemäßes Target rechteckig ausgebildet werden, wobei vorzugsweise die Breite des Targets zwischen 50 mm bis 250 mm liegt und die Länge des Targets zwischen 200 mm und 2000 mm.

Das Größenverhältnis senkrecht zur Targetoberfläche bzw. das Verhältnis der Dicke der Stabilisierungsschicht zur Dicke der Targetplatte liegt vorzugsweise zwischen 1/1 und 1/5, besonders bevorzugt liegt das Verhältnis bei 1/2 bis 1/4. Beispielsweise weist die Stabilisierungsschicht eine Dicke zwischen 1 mm und 10 mm, vorzugweise zwischen 2 mm und 5 mm auf, z.B. hat die Targetplatte eine Dicke von 8 mm und die Stabilisierungsschicht eine Dicke von 4 mm. Vorzugsweise ragt die Stabilisierungsschicht zumindest teilweise seitlich über einen Rand der Targetplatte hinaus. Besonders bevorzugt bildet die Stabilisierungsschicht einen umlaufenden Flansch aus. D.h. mittels der gespritzten Stabilisierungsschicht kann das Target einfach in einer PVD-Anlage eingespannt werden, ohne dass das Targetmaterial z.B. von einer Klemmvorrichtung abgedeckt wird. Alternativ können die Stabilisierungsschicht und die Targetplatte seitlich bündig ausgebildet sein.

Bevorzugt weist die Rückseite der Targetplatte zumindest eine Vertiefung auf, beispielsweise eine (oder mehrere) zum Beispiel spiralförmige Rille(n), Nut(en) und/oder Kerbe(n), so dass eine profilierte Oberfläche mit einer Vielzahl von Vertiefungen bzw. Erhebungen vor dem Aufbringen der Stabilisierungsschicht bereitgestellt wird. Da die Targetplatte durch die Vertiefungen (Erhebungen) eine größere Oberfläche erhält, ist die Verbindung zwischen Targetplatte und Stabilisierungsschicht stabiler und die Steifigkeit des Targets wird erhöht. Eine solche Ausgestaltung ist besonders vorteilhaft wenn das Stabilisierungsmaterial einen zum Targetmaterial unterschiedlichen thermischen Ausdehnungskoeffizienten aufweist. Zusätzlich ist durch die Vertiefungen bzw. Erhebungen bereitgestellte größere Oberfläche der Rückseite der Targetplatte eine verbesserte Wärmeabfuhr gegeben.

In einer bevorzugten Ausgestaltung weist das Target eine zwischen Targetplatte und Stabilisierungsschicht angeordnete diffusionsfördernde Schicht zur Haftvermittlung auf. Ein Beispiel für eine solche haftvermittelnde Schicht ist galvanisch aufgebrachtes Nickel.

Die Rückseite eines erfindungsgemäßen-Targets kann in Ausgestaltungen ein Gewinde bzw. Ausnehmungen beispielsweise für die Aufnahme von Magneten aufweisen.

Ein erfindungsgemäßes Verfahren nach Anspruch 6 zur Herstellung eines insbesondere wie oben beschriebenen Targets stellt zunächst eine Targetplatte bereit. Auf deren Rückseite wird anschließend Stabilisierungsmaterial mittels eines hochkinetischen Spritzverfahrens aufgespritzt, so dass auf der Rückseite der Targetplatte eine Stabilisierungsschicht erzeugt bzw. aufgebaut wird. Die für ein erfindungsgemäßes Verfahren einzustellenden Parameter wie zum Beispiel die Wahl des Prozessgases, Prozessgasdruck, Prozesstemperatur, Abstand zur Targetplatte, Spritzwinkel können einfach im Zuge eines Optimierungsdurchganges ermittelt werden. Ebenso können für ein erfindungsgemäßes Verfahren verwendbare Pulver oder Pulvermischungen im Zuge eines Optimierungsdurchganges hinsichtlich ihrer Zusammensetzung, Partikelgröße, Partikelform und Partikelgrößenverteilung ermittelt werden. Die Bestimmung der Partikelgröße bzw. Partikelgrößenverteilung erfolgt in einfacher Weise über eine Trockenmessung mittels Malvern Mastersizer 2000.

Besonders bevorzugt wird vor dem Aufspritzen des Stabilisierungsmaterials auf der Targetplatte zumindest eine Vertiefung auf der Rückseite der Targetplatte erzeugt bzw. hergestellt. D.h. die Targetplattenrückseite wird profiliert, z.B. durch eine Vielzahl von nebeneinanderliegenden Vertiefungen, wie runde oder eckige Löcher, oder Rillen.

Vor dem Aufbringen der Stabilisierungsschicht kann auf die Targetplatte eine diffusionsfördernde Schicht zur Haftvermittlung aufgebracht werden, um die Anbindung zwischen Targetplatte und Stabilisierungsschicht weiter zu erhöhen. Eine solche Schicht kann z.B. galvanisch aufgebracht werden, es sind aber auch andere Methoden für die Abscheidung möglich, wie zum Beispiel über PVD oder Suspensionsbeschichtung.

Optional kann nach dem Aufspritzen des Stabilisierungsmaterials eine Wärmebehandlung erfolgen, wodurch gegebenenfalls entstandene und in Targetplatte und oder Stabilisierungsschicht verbliebene Eigenspannungen abgebaut werden können. Durch eine solche optionale Wärmebehandlung können auch Diffusionsvorgänge an der Grenzfläche zwischen Targetplatte und Stabilisierungsschicht, bzw. bei mehrschichtigen Stabilisierungsschichten zwischen den Teilschichten, angeregt und die Haftung somit weiter verbessert werden.

Vorzugsweise findet nach dem Auftragen der Stabilisierungsschicht eine Endbearbeitung der miteinander verbundenen Targetplatte und Stabilisierungsschicht statt. Beispielsweise mittels Drehen, Fräsen und/oder Schleifen wird das Target bearbeitet, bis es die gewünschten Endabmessungen aufweist. Durch eine solche mechanische Bearbeitung kann beispielsweise auch ein Gewinde in die Rückseite des erfindungsgemäßen Targets geschnitten, sowie Ausnehmungen beispielsweise für die Aufnahme von Magneten bereitgestellt werden.

Einzelne Merkmale der oben und unten beschriebenen Ausführungen des Targets und des Verfahrens zur Herstellung eines Targets können auf beliebige Weise miteinander kombiniert werden.

**Tabelle 1: Beispiele für Abmessungen erfindungsgemäßer Targets**

| Durchmesser und Dicke scheibenförmiger Targets | Breite, Länge und Dicke rechteckiger Targets |
|---|---|
| Ø 63 mm x 32 mm | 400 mm x 88 mm x 10 mm |
| Ø 105 mm x 16 mm | 500 mm x 88 mm x 10 mm |
| Ø 105 mm x 15 mm | 200 mm x 88 mm x 10 mm |
| Ø 160 mm x 12 mm | 14 mm x 176 mm x 911 mm |
| Ø 150 mm x 6 mm | 14 mm x 132 mm x 609 mm |
| Ø 148 mm x 12 mm | 12 mm x 170 mm x 1.000 mm |
| | 12 mm x 170 mm x 830 mm |
| | 12 mm x 125 mm x 150 mm |
| | 12 mm x 125 mm x 600 mm |

**Tabelle 2: Werkstoffdaten für in einem erfindungsgemäßen Target verwendbare Werkstoffe**

| Werkstoff | Elastizitätsmodul [GPa] | Streckgrenze bei Raumtemperatur [MPa] | Wärmeleitfähigkeit [W/(m*K)] |
|---|---|---|---|
| Aluminium | 70 | 40 | 220 |
| Chrom | 190 | Keine Angaben wegen Sprödigkeit | 70 |
| Titan | 105 | 220 | 20 |
| WC | 710 | Keine Angaben wegen Sprödigkeit | 120 |
| TiB₂ | 365 | Keine Angaben wegen Sprödigkeit | 100 |
| Kupfer | 125 | 160 | 390 |
| Stahl 1.4404 | 195 | 350 | 20 |

Sowohl die in Tabelle 1 angegebenen Dimensionen als auch die in Tabelle 2 angegebenen Werte sind als Richtwerte zu verstehen. Es sind natürlich auch andere Dimensionen sowie andere Werkstoffe herstell- bzw. verwendbar.

Bei den Werkstoffdaten in Tabelle 2 handelt es sich um Richtwerte, da vor allem die Streckgrenze stark von der Mikrostruktur, dem Legierungs- bzw. Verunreinigungsgehalt sowie dem Wärmebehandlungszustand beeinflusst wird.

Anhand der Figuren werden Ausführungsformen der Erfindung näher erläutert. Es zeigen:
- Fig. 1: eine schematische Darstellung eines Teils einer Spritzanlage für ein hochkinetisches Spritzverfahren,
- Fig. 2a-b: zwei geschnittene schematische Seitenansichten zweier Ausgestaltungen eines Targets,
- Fig. 3: einen geätzten Querschliff eines Kupfer-Bulkmaterials,
- Fig. 4: einen geätzten Querschliff einer Kupfer-Schicht, die mittels eines hochkinetischen Spritzverfahrens (Kaltgasspritzen) aufgebracht wurde,
- Fig. 5: einen geätzten Querschliff des Grenzbereichs zwischen einer Targetplatte aus AlCr 70/30 at% und einer gespritzten Stabilisierungsschicht aus Cu, und
- Fig. 6: einen geätzten Querschliff des Grenzbereichs zwischen einer Targetplatte aus Cr und einer gespritzten Stabilisierungsschicht aus Stahl.

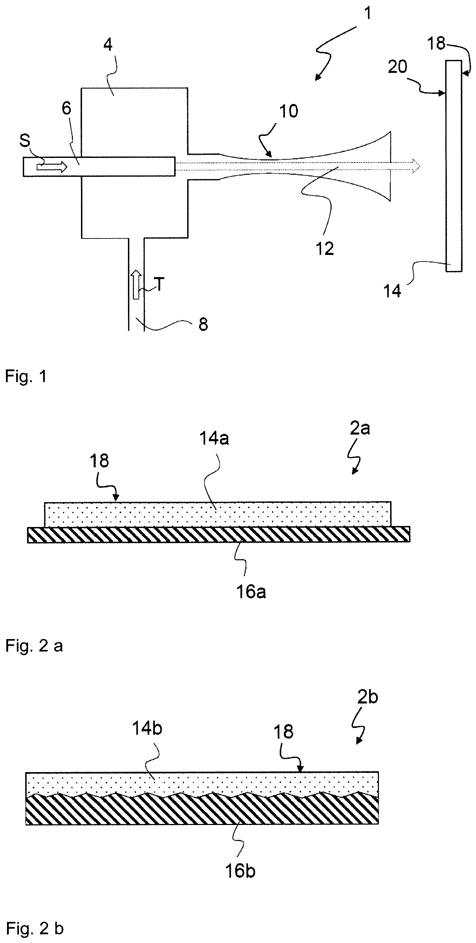

Fig. 1 zeigt eine schematische Darstellung eines Teils einer Spritzanlage 1 für ein hochkinetisches Spritzverfahren zur Erläuterung des Prinzips. Ein Spritzpistolengehäuse 4 weist eine Konvergent-/Divergentdüse 10 auf, um ein durch eine Prozessgasleitung 8 zugeführtes Prozessgas T auf Überschallgeschwindigkeit zu beschleunigen. In den beschleunigten Prozessgasstrom T wird über eine Spritzmaterialleitung 6 ein Spritzmaterial S, d.h. eine Vielzahl von Partikeln, eingebracht, die durch den Prozessgasstrom T zur Rückseite 20 der Targetplatte 14 hin beschleunigt werden. Dort prallt der Spritzmaterial-Strahl auf und bleibt auf der Rückseite der Targetplatte 14 haften. Die Vorderseite 18 der Targetplatte 14 entspricht der Seite, die bei einem PVD Abscheideverfahren einem zu beschichtenden Substrat zugewandt ist.

Durch das Spritzen baut sich auf der Rückseite 20 der Targetplatte 14 eine Schicht aus dem Spritzmaterial S auf. Wie in Fig. 2a-b dargestellt, wird der Spritzvorgang so lange durchgeführt, bis sich eine Stabilisierungsschicht 16a-b ausbildet. Durch das Spritzen haftet das Spritzmaterial S äußerst stabil auf der Targetplatte 14a-b bzw. auf dem Targetmaterial. Dies ist besonders vorteilhaft wenn sich die verwendete Targetplatte aufgrund des technologisch bedingten Herstellungsweges bzw. der technologischen Rahmenbedingungen nur schlecht mit dem für die Stabilisierungsschicht verwendeten Werkstoff verbinden lässt.

Gemäß der vorliegenden Erfindung wird während des Spritzens die Zusammensetzung des Stabilisierungsmaterials verändert, so dass sich ein Gradientenverlauf in der Stabilisierungsschicht 16a-b ergibt. Dabei wird die Zusammensetzung so verändert, dass die Festigkeit und Steifigkeit der erzeugten Stabilisierungsschicht 16a-b erhöht wird. Beispielsweise wird zu Beginn des Spritzens reines Kupfer verwendet und dem Kupfer nach und nach ein oder mehrere Elemente zugegeben, so dass eine Stabilisierungsschicht mit höherer Festigkeit und Steifigkeit erhalten wird. Alternativ kann die gesamte Stabilisierungsschicht homogen aus einer Kupferlegierung oder einem Kupfer-Verbundwerkstoff hergestellt sein.

Wie in Fig. 2a zu sehen, ragt die Stabilisierungsschicht 16a seitlich über die Targetplatte 14a hinaus und bildet einen (durchgehenden oder unterbrochenen) Flansch, mittels dem das Target 2a in einer PVD-Anlage befestigt werden kann.

Wie in Fig. 2b zu sehen, können alternativ die Targetplatte 14b und die Stabilisierungsschicht 16b seitlich bündig ausgebildet sein, je nach Art der vorhandenen Befestigungseinrichtung in der PVD-Anlage.

Fig. 2b zeigt eine weitere Ausgestaltung eines Targets 2b, bei dem eine Targetplatte 14b auf ihrer Rückseite eine Vielzahl von Vertiefungen bzw. Erhebungen aufweist, in die bei der Herstellung mittels eines hochkinetischen Spritzverfahrens das Stabilisierungsmaterial gespritzt wird. D.h. die Oberfläche der Targetplatte 14b wird durch die Profilierung vergrößert, wodurch sich die Stabilität der Verbindung zwischen Targetplatte 14b und Stabilisierungsschicht 16b erhöht und zusätzlich durch die geometrische Gestaltung die Steifigkeit des Targets 2b gesteigert wird. Auch die Wärmeabfuhr wird durch die vergrößerte Oberfläche verbessert.

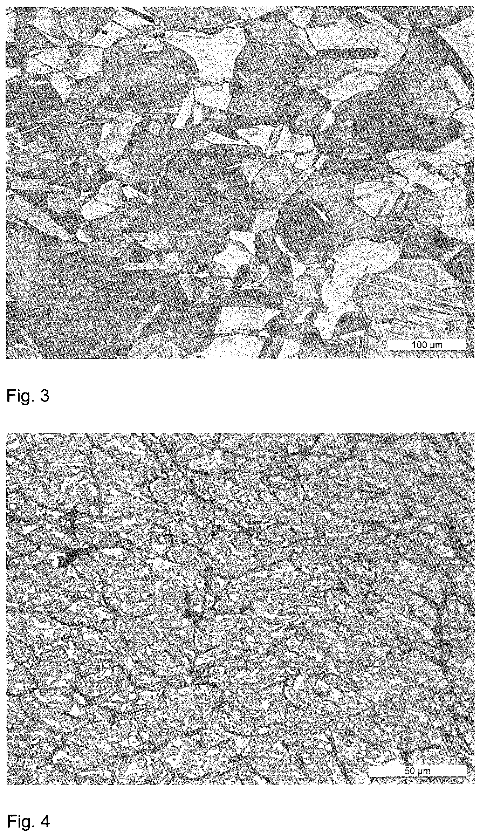

Fig. 3 zeigt einen geätzten Querschliff eines Kupfer-Bulkmaterials. Im Vergleich dazu zeigt Fig. 4 einen geätzten Querschliff einer Kupferschicht, die mittels Kaltgasspritzen aufgebracht wurde, wobei die Partikelgrenzen zur Verdeutlichung der Mikrostruktur überätzt wurden. Das verwendete Kupferpulver hat eine mittlere Partikelgröße kleiner 45 µm, wobei auch Kupferpulver mit anderen Partikelgrößen benutzt werden können, beispielsweise Partikelgrößen im 100 µm-Bereich (von einigen zehn bis ca. 150 µm Partikelgröße). Konkret wurde für die in Fig. 4 abgebildete Kupferschicht ein Pulver mit einer mittleren Partikelgröße von 31,0 µm, einem D10-Wert von 11,2 µm, einem D50-Wert von 28,9 µm sowie einem D90-Wert von 53,8 µm verwendet.

Im Vergleich von Fig. 3 und Fig. 4 ist klar zu erkennen, dass sich durch den Spritzvorgang ein Gefüge mit verformter Mikrostruktur ausbildet. So ergibt sich in diesem Beispiel eine längliche Ausprägung der Cu-Partikel mit einem mittleren Aspektverhältnis von größer 2.

### Beispiel 1 (nicht erfindungsgemäß):

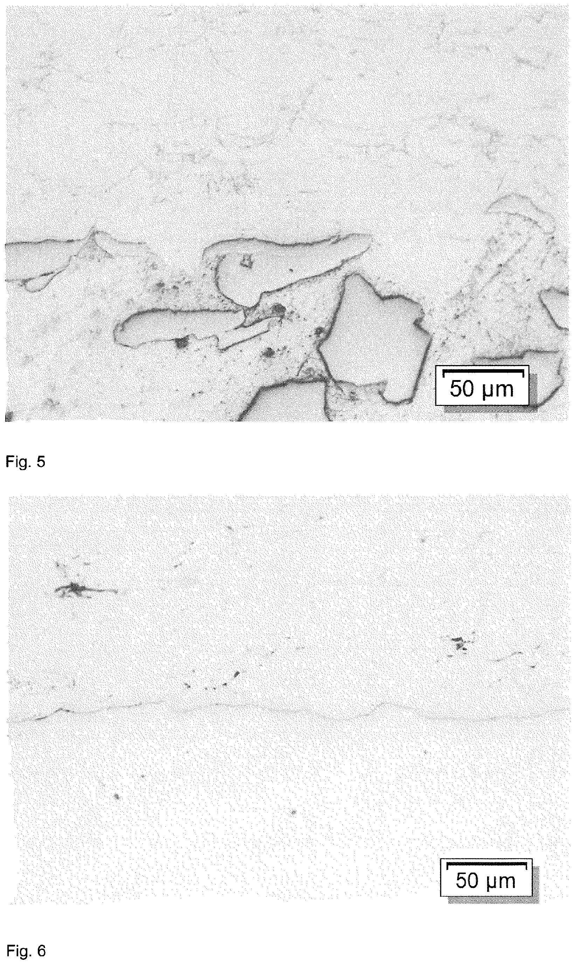

Fig. 5 zeigt einen geätzten Querschliff des Grenzbereichs zwischen einer Targetplatte und einer kaltgasgespritzten Stabilisierungsschicht aus reinem Kupfer. Das Gefüge der Targetplatte aus AlCr 70/30 at% besteht aus einer verdichteten Mischung aus Aluminium-Partikeln mit eingebetteten Chrom-Partikeln, also einem Aluminium-Chrom-Verbundwerkstoff. Darauf wurde mittels Kaltgasspritzen eine Stabilisierungsschicht aus Kupfer aufgebracht. Durch das Kaltgasspritzen wird eine äußerst stabile Verbindung zwischen den beiden Materialien Kupfer und dem Aluminium-Chrom-Verbundwerkstoff hergestellt. Insbesondere wird durch die hohe Beschleunigung beim Kaltgasspritzen das Kupfer in die Targetplatte "geschossen", so dass die beiden Materialien im Grenzbereich miteinander verzahnt sind. Die erreichte relative Dichte des kaltgasgespritzten Kupfers als Stabilisierungsmaterial beträgt im abgebildeten Fall 99,3%, es konnte keine durch den Spritzvorgang verursachte zusätzliche Gasaufnahme in der Schicht festgestellt werden. Die mittlere Partikelgröße der Stabilisierungsschicht aus Kupfer liegt in diesem Ausführungsbeispiel bei < 45 µm in Dickenrichtung des Targets. Die Stabilisierungsschicht wurde in Zeilen bei einem Druck von 32 bar unter einer Temperatur von 500°C mit Stickstoff gespritzt, der Spritzwinkel betrug 90°, der Abstand zur Targetplatte 30 mm.

### Beispiel 2 (nicht erfindungsgemäß):

Fig. 6 zeigt einen geätzten Querschliff des Grenzbereichs zwischen einer Targetplatte aus Chrom und einer mittels Wasserdampfauftragsverfahren hergestellten Stabilisierungsschicht aus Stahl. Eine Schicht aus Stahl kann sowohl als einzelne Stabilisierungsschicht als auch zusätzlich als Ergänzung zu einer Schicht aus einer Kupfer-Legierung oder Kupfer verwendet werden, insbesondere wenn eine Rückplatte mit weiter erhöhter Streckgrenze oder Steifigkeit hergestellt werden soll. Die zwei Materialien (Kupfer und Stahl) haben in diesem Fall zwei unterschiedliche Wirkungsweisen: Kupfer sorgt dafür, dass die Wärme von der Targetplatte effizient abgeleitet und somit das Targetmaterial nicht thermisch überlastet wird, Stahl sorgt durch die höhere Streckgrenze und höhere Steifigkeit dafür, dass das Targetmaterial den anlagenbedingten Drücken standhält und schützt somit das Material vor Verformung bzw. Bruch.

Die in Fig. 6 abgebildete nicht erfindungsgemäße Stabilierungsschicht aus Stahl wurde direkt auf eine Targetplatte aus Chrom aufgebracht. Es handelte sich dabei um ein 1.4404 Stahlpulver mit einer mittleren Pulverpartikelgröße < 63 µm. Konkret wurde für die in Fig. 6 abgebildete Stahlschicht ein Pulver mit einer mittleren Partikelgröße von 55,9 µm, einem D10-Wert von 26,9 µm, einem D50-Wert von 53,8 µm sowie einem D90-Wert von 88,1 µm verwendet. Die erreichte relative Dichte des wasserdampfaufgebrachten Stahls als Stabilisierungsmaterial beträgt im abgebildeten Fall 98%, es konnte keine durch den Spritzvorgang verursachte zusätzliche Gasaufnahme in der Schicht festgestellt werden. Die Stabilisierungsschicht aus Stahl wurde in mehreren Zeilen und mehreren aufeinanderfolgenden Schichten bei einer Temperatur von 400°C am Substrat mit Wasserdampf gespritzt, der Spritzwinkel betrug 90°, der Abstand zur Targetplatte 65 mm.

### Bezugszeichenliste

- 1: Spritzanlage für ein hochkinetisches Spritzverfahren
- 2a-b: Target
- 4: Spritzpistolengehäuse
- 6: Spritzmaterialleitung
- 8: Prozessgasleitung
- 10: Konvergent-/Divergentdüse
- 12: Spritzmaterial- + Trägergaszufuhr
- 14, 14a-b: Targetplatte
- 16a-b: Rückplatte / Stabilisierungsschicht
- 18: Targetplattenvorderseite
- 20: Targetplattenrückseite

- S: Spritzmaterial- + Trägergasstrom
- T: Prozessgasstrom

## Patentansprüche

1. Target (2a-b) aufweisend eine Targetplatte (14a-b), und eine Stabilisierungsschicht (16a-b), die mit der Rückseite der Targetplatte (14a-b) verbunden ist, wobei die Stabilisierungsschicht (16ab) mittels eines hochkinetischen Spritzverfahrens von Stabilisierungsmaterial auf die Targetplatte (14a-b) aufgebracht ist, **dadurch gekennzeichnet, dass** die Zusammensetzung der Stabilisierungsschicht (16a-b) einen Gradientenverlauf aufweist.

2. Target nach Anspruch 1, **dadurch gekennzeichnet, dass** die Targetplatte (14a-b) aus einem Werkstoff ausgewählt aus der Gruppe Aluminium-Basis Werkstoffe, Chrom-Basis Werkstoffe, Titan-Basis Werkstoffe und Keramiken hergestellt ist.

3. Target nach Anspruch 1 oder 2, **dadurch gekennzeichnet, dass** die Stabilisierungsschicht (16a-b) aus einem oder mehreren Werkstoffen ausgewählt aus der Gruppe Kupfer, Kupferlegierungen inklusive Messing und Bronzen, Aluminium, Aluminiumlegierungen, Titan, Titanlegierungen und Stahl hergestellt ist.

4. Target nach einem der vorangehenden Ansprüche, **dadurch gekennzeichnet, dass** das Verhältnis der Dicke der Stabilisierungsschicht (16a-b) zur Dicke der Targetplatte (14a-b) zwischen 1/1 und 1/5 liegt.

5. Target nach einem der vorangehenden Ansprüche, **dadurch gekennzeichnet, dass** die Rückseite der Targetplatte (14b) zumindest eine Vertiefung aufweist.

6. Verfahren zur Herstellung eines Targets, insbesondere eines Targets (2a-b) nach einem der vorangehenden Ansprüche, **dadurch gekennzeichnet, dass** das Verfahren folgende Schritte enthält:
- Bereitstellen einer Targetplatte (14a-b)
- Aufspritzen von Stabilisierungsmaterial auf die Targetplatte (14a-b) mittels eines hochkinetischen Spritzverfahrens, so dass auf der Rückseite der Targetplatte (14a-b) eine Stabilisierungsschicht (16a-b) erzeugt wird und die Zusammensetzung der Stabilisierungsschicht (16ab) einen Gradientenverlauf aufweist.

7. Verfahren nach Anspruch 6, **dadurch gekennzeichnet, dass** dieses folgenden Schritt enthält:
- Aufbringen einer diffusionsfördernden Schicht zur Haftvermittlung.

## Claims

1. Target (2a-b) having a target plate (14a-b) and a stabilizing layer (16a-b) which is joined to the rear side of the target plate (14a-b), wherein the stabilizing layer (16a-b) has been applied to the target plate (14a-b) by means of high-kinetic-energy spraying of stabilizing material, **characterized in that** the composition of the stabilizing layer (16a-b) has a gradient.

2. Target according to Claim 1, **characterized in that** the target plate (14a-b) is made of a material selected from the group (aluminium-based materials, chromium-based materials, titanium-based materials and ceramics).

3. Target according to Claim 1 or 2, **characterized in that** the stabilizing layer (16a-b) is made of one or more materials selected from the group (copper, copper alloys, including brass and bronzes, aluminium, aluminium alloys, titanium, titanium alloys and steel).

4. Target according to any of the preceding claims, **characterized in that** the ratio of the thickness of the stabilizing layer (16a-b) to the thickness of the target plate (14a-b) is in the range from 1/1 to 1/5.

5. Target according to any of the preceding claims, **characterized in that** the rear side of the target plate (14b) has at least one depression.

6. Process for producing a target, in particular a target (2a-b) according to any of the preceding claims, **characterized in that** the process comprises the following steps:
- provision of a target plate (14a-b)
- spraying of stabilizing material onto the target plate (14a-b) by means of a high-kinetic-energy spraying process so that a stabilizing layer (16a-b) is produced on the rear side of the target plate (14a-b) and the composition of the stabilizing layer (16a-b) has a gradient.

7. Process according to Claim 6, **characterized in that** it comprises the following step:
- application of a diffusion-promoting layer to aid bonding.

## Revendications

1. Cible (2a-b) comprenant une plaque cible (14a-b) et une couche de stabilisation (16a-b) qui est liée au côté arrière de la plaque cible (14a-b), la couche de stabilisation (16a-b) étant appliquée sur la plaque cible (14a-b) au moyen d'un procédé de pulvérisation à haute énergie cinétique de matériau de stabilisation, **caractérisée en ce que** la composition de la couche de stabilisation (16a-b) présente un profil de gradient.

2. Cible selon la revendication 1, **caractérisée en ce que** la plaque cible (14a-b) est réalisée à partir d'une matière choisie dans le groupe des matières à base d'aluminium, des matières à base de chrome, des matières à base de titane et des céramiques.

3. Cible selon la revendication 1 ou 2, **caractérisée en ce que** la couche de stabilisation (16a-b) est fabriquée à partir d'au moins une matière choisie dans le groupe comprenant le cuivre, des alliages de cuivre dont le laiton et les bronzes, l'aluminium, des alliages d'aluminium, le titane, des alliages de titane et l'acier.

4. Cible selon l'une des revendications précédentes, **caractérisée en ce que** le rapport de l'épaisseur de la couche de stabilisation (16a-b) à l'épaisseur de la plaque cible (14ab) est compris entre 1/1 et 1/5.

5. Cible selon l'une des revendications précédentes, **caractérisée en ce que** le côté arrière de la plaque cible (14b) comporte au moins un évidement.

6. Procédé de fabrication d'une cible, notamment d'une cible (2a-b) selon l'une des revendications précédentes, **caractérisé en ce que** le procédé comprend les étapes suivantes :
- fournir une plaque cible (14a-b)
- pulvériser un matériau de stabilisation sur la plaque cible (14a-b) à l'aide d'un procédé de pulvérisation à haute énergie cinétique de façon à générer sur le côté arrière de la plaque cible (14a-b) une couche de stabilisation (16a-b) et de manière à ce que la composition de la couche de stabilisation (16a-b) présente un profil de gradient.

7. Procédé selon la revendication 6, **caractérisé en ce qu'**il comprend l'étape suivante :
- appliquer une couche favorisant la diffusion en vue de l'adhérence.
